# EUROPEAN PATENT SPECIFICATION

(11) **EP 3 792 372 B1**
(45) Date of publication and mention of the grant of the patent: **02.08.2023**
(21) Application number: 20191136.9
(22) Date of filing: 14.08.2020
(51) Int. Cl.: C23C 14/06, F28F 19/02, C23C 14/35, C23C 16/34, F28D 20/02, F28D 20/00

(54) **ANTICORROSIVE HIGH THERMAL CONDUCTIVITY ALN COATING FOR METALLIC SURFACES IN CONTACT WITH SALT HYDRATES AND ITS APPLICATION TO HEAT EXCHANGERS USED IN THERMAL ENERGY STORAGE SYSTEMS**
ANTIKORROSIVE BESCHICHTUNG MIT HOHER WÄRMELEITFÄHIGKEIT FÜR METALLISCHE OBERFLÄCHEN IN KONTAKT MIT SALZHYDRATEN UND IHRE ANWENDUNG AUF WÄRMETAUSCHER, DIE IN THERMISCHEN ENERGIESPEICHERSYSTEMEN VERWENDET WERDEN
REVÊTEMENT ANTICORROSIF À HAUTE CONDUCTIVITÉ THERMIQUE POUR LES SURFACES MÉTALLIQUES EN CONTACT AVEC DES HYDRATES DE SEL ET SON APPLICATION AUX ÉCHANGEURS DE CHALEUR UTILISÉS DANS LES SYSTÈMES DE STOCKAGE DE L'ÉNERGIE THERMIQUE

(30) Priority: 16.08.2019 PT 2019115740
(43) Date of publication of application: 17.03.2021
(73) Proprietor: Instituto Politécnico de Setúbal, 2910-761 Setúbal (PT); Panepistimio loanninon (UOI), Ioannina 45110 (GR); Centre for Renewable Energy Sources and Saving Foundation (CRES), Pikermi 19009 (GR); National and Kapodistrian University of Athens (NKUA), Special Account for Research Grants (SARG), 105 61 Athens (GR)
(72) Inventor: PANAGIOTOPOULOS, N.T., 45110 Ioannina (GR); LEKATOU, A.G., 45110 Ioannina (GR); TSOULI, S., 45110 Ioannina (GR); PROUSKAS, C., 45110 Ioannina (GR); VRACHOPOULOS, M., 34400 Psachna, Chalkida (GR); KOUKOU, M., 34400 Psachna, Chalkida (GR); KARYTSAS, C., 19009 PIKERMI (GR); EVANGELAKIS, G.A., 45110 Ioannina (GR); COELHO, LUÍS, 2910-761 Setúbal (PT)
(74) Representative: Lourenço Martinho do Rosário, Ana Margarida

(56) References cited:
- CN-A- 108 796 462
- US-A- 6 035 927
- US-A1- 2018 122 959

## Description

### Field of the invention

The present invention refers to the protection of metallic surfaces against corrosion from salt hydrates, while preserving the metallic thermal characteristics with application to heat exchangers, which are the structural elements used in thermal storage applications, using AlN film as anticorrosive coating.

### Framework of the invention

Among the renewable energy sources, solar and geothermal energy sources provide thermal energy directly. This gained thermal energy can be stored in thermal energy systems (TES) and used according to the energy needs. In general, TES consist of a thermal energy storage medium and a closed circuit heating-cooling system. The heat storage in the TES storage media can efficiently be achieved using the latent heat upon phase change [1,2,3,4]. The latent heat storage method has attracted great interest due to the fact that high density energy storage within a small temperature window can be achieved [3,5]. Heating and cooling an edification using the latent method can lead to a more sufficient energy management. This is because the internal edification temperature can be kept within the human comfort zone with less temperature fluctuations, thus minimizing peak heating and cooling consumption loads [5].

A group of materials that can be used as latent heat storage media are the phase change materials (PCM). PCM are substances designed to undergo a nearly isothermal phase transition at specific temperatures and thus, releasing or absorbing thermal energy to and from the environment [1,2,6]. They are classified into organic, inorganic and eutectic PCMs [2]. The inorganic PCMs, such as the salt hydrates, are widely studied and applied due to their high thermal conductivity, high heat of fusion, low volume change and low-cost production. However, they have the disadvantage of being highly corrosive: a property that may cause severe failure of the Heat Exchangers (HE) used in TES systems [6-8]. In a passive way of utilisation, the inorganic PCMs can be integrated in various edification metallic containers, like plates and vessels, internal blinds and aluminium profiles with the purpose of increasing the heat transfer rate maintaining the air temperature as stable as possible [1,9]. In a more dynamic way of utilisation, the inorganic PCM materials can be deposited in storage units and tanks [8-10]. In this way, heat transfer from the storage tank to the edification is achieved using embedded HE in the PCM [7-11] .

The inorganic PCM heat exchangers are usually made of aluminium, copper, brass or stainless steels due to their high thermal conductivity properties [7,12]. As they are in direct contact with the PCM, their corrosion protection abilities are of a major significance.

A method to examine and assess the corrosion performance of a material in real functioning conditions is the reverse polarization. The corrosion properties of testing material are examined by potentiodynamic polarization tests in aqueous environments. Electrolytes that can be used is an inorganic PCM (3,5 wt. % Mg(NO₃)₂+MgCl₂) and 3,5 wt. % NaCl. Polarization tests in 3,5 wt.% NaCl, a solution that mimics saline environments, are carried out to see the response of the testing material to a highly destructive environment for Al. Potentiodynamic polarization tests can be performed at an AC potentiostat/galvanostat. A standard three-electrode cell can be employed with Ag/AgCl (3,5 M KCl, EAgCl = ESHE - 200 mV, SHE: Standard Hydrogen Electrode) as the reference electrode and a platinum gauze as the counter electrode. The rest potential is determined after 2h of immersion in the electrolytes (open-circuit state). Following determination of the rest potential, polarization has started at a scan rate of 10 mV/min.

The corrosion current densities are calculated by Tafel extrapolation [31,32]. The susceptibility of the alloys to localized corrosion is investigated by reverse polarization. The main concept of this technique is that localized corrosion would occur if the current density of the anodic portion of the return scan is higher than the current density of the forward scan for the same anodic potential [33]. This type of hysteresis is labelled as "negative hysteresis".

Additional and complementary methods to examine the anticorrosion properties and behaviour of a material are surface characterization techniques prior and post cyclic polarization tests. Grazing incidence X-ray diffraction (GID) and scanning electron microscopy (SEM) are employed for the structural characterization while chemical surface analysis is performed by energy dispersive spectroscopy (EDS) and X-ray photoelectron spectroscopy (XPS).

The corrosion issues related with the HE metals may be tackled with the selection of the appropriate structural metallic material that can withstand each specific inorganic PCM [7,12,13-15]. Thin films composed of diamond-like carbon (DLC), metal carbides, nitrides, and oxides and grown either by physical or chemical vapour deposition techniques are widely used as anticorrosive coatings against aggressive environments [16-22]. Among them, aluminium nitride (AlN) is one of the few materials that can be produced at industrial scale, whilst it combines high thermal conductivity [23-26] and anticorrosive behaviour [27-30].

The technical problem solved by this invention refers to a cathodic corrosion protection solution of the thermal energy systems (TES) metallic Heat Exchangers (HE) components against inorganic PCMs by depositing AlN film to serve as anticorrosive coating using an industrial scale method, i.e. magnetron sputtering method, while preserving the high thermal conductivity that is required especially for the HE. The solution of the technical problem should enable application of AlN films as anticorrosive coatings for the corrosion protection of the structural metallic materials of HE used in TES according to the methods of the invention, the AlN nitride film should be coated by an industrial accessible deposition technique and protect the HE components against corrosion by salt hydrates PCM.

### Background of the invention

Patent US6035927 discloses a heat-insulating coating on the surfaces of a heat exchanger. The heat-insulating coating can be aluminium nitride. T

Aluminium nitride films have been reported as anticorrosion coatings of metallic materials against various corrosive environments. AlN can be noticeable as more chemically stable than metals and alloys in various corrosive environments, and therefore, serve as an interlayer preventing the direct contact of the corrosive solute with the metallic material.

Corrosion protection of metallic components using AlN coatings is still a challenging and evolving filed of research as described in several papers.

Hatwa et al. [T.K. Hatwa et al., IEEE Transactions on magnetics 22 (1986) 946-948;] report magnetron sputtered AlN as replacing protective overcoat of better corrosion properties than the common in use SiO₂ for the corrosion protection of a magnetooptical layer TbFe film as tested by potentiodynamic polarization in pH = 3,1 KCl/chloroacetate buffer.

Altun and Sen [H. Altun and S. Sen, Surface & Coatings Technology 197 (2005) 193-200;] report the corrosion protection of magnesium alloys (AZ31, AZ61, AZ63, and AZ91) by magnetron sputtered AlN against 0,6 M NaCl.

Tait and Aita [W.S. Tait and C.R. Aita, Corrosion 46 (1990) 115-117; C.R. Aita and W.S. Tait, Nanostructured Materials 1 (1992) 269-282;] report the corrosion protection of coated 1008 mild steel in oxygen-free and in O₂-purged 0,2 M KCl by magnetron sputtered nanocrystalline AIN.

Choudhary et al. [R. K. Choudhary et al., Transactions of the IMF, 94 (2016) 250-253;] report enhanced corrosion resistance of AlN-coated stainless steel by magnetron sputtering in dilute sulphuric acid solutions (0,5 M H₂SO₄) as studied by electrochemical corrosion measurements.

Hübler et al. [R. Hübler et al., Nuclear Instruments and Methods in Physics Research B80/81 (1993) 1415-1418;] report corrosion protection from aqueous acetate buffer solution of pH 5,6 at 25°C of CK45 steel (0,42 wt %C) by the deposited multilayers AlN/Al grown by magnetron sputtering. Al layer serves as a buffer layer for a better adhesion of AlN on the testing substrate.

Subramanian et al. [B. Subramanian et al., Vacuum 85 (2010) 601-609;] report better corrosion properties of AISI 316L stainless steel and low carbon steel, tested in simulated bodily fluid solution and 3,5% NaCl, due to deposited TiN, AlN and Ti_{0.5}Al_{0.5}N coatings.

Young and Duh [C.-D. Young and J-G. Duh, journal of materials science 30 (1995) 185-195;] studied the corrosion resistance of AlN in acid, basic solutions and deionized water reporting high corrosion rates in basic solutions (70% weight loss after corrosion) while in acidic solutions of pH < 7 the weight difference was found to be negligible.

Svedberg et al., [L.M. Svedberg et al., J. Am. Ceram. Soc. 83 (2000) 41-46;] studied the corrosion behaviour of AlN powder and substrates in aqueous solutions in pH range from 5,5 to 12 reporting the protection of AlN by the formation of a thin protective oxide layer, whilst the thermal conductivity of AlN being decreased by 6,6%.

Yang et al. [H. Tang et al., Materials Transactions, 47 (2006) 1649-1653;] studied the corrosion resistance against of AlN/Al₂O₃ composite coatings deposited on mild steel by plasma spray. Corrosion tests were performed in 1 M HCl at 20 and 80°C showing that the higher the AlN content the better the corrosion protection, especially at 80°C, and the thermal conductivity is.

### Advantages of the invention

Despite the aforementioned studies on the anticorrosion properties of AlN films and correction protection of various substrates in aqueous solutions, the use of AlN films as anticorrosion coatings against salt hydrates PCM environments used in TES is an unexplored filed of research and highly promising considering the minimum thermal losses and thermal hysteresis during thermal exchanges due to the high thermal conductivity of AlN.

### Brief description of the drawings

These and other characteristics can be easily understood by means of the attached drawings, which are to be considered as mere examples and in no way restrictive of the scope of the invention. In the drawings, and for illustrative purposes, the measurements of some of the elements may be exaggerated and not drawn to scale. The absolute and relative dimensions do not correspond to the real ratios for the embodiments of the invention.

In a preferred embodiment:
Figure 1: Crystallographic structure of as-grown AlN on Al1050. (XRD)
Figure 2: Potentiodynamic polarization behaviour of AlN coating and Al1050 in a) 3,5 wt. % NaCl and b) 3,5 wt. % Mg(NO₃)₂+MgCl₂, at 25°C.
Figure 3: Grazing incidence XRD of as-deposited (bottom black line) and Mg-salt exposed AlN/Al1050 (top line).
Figure 4: Electron micrographs of the AlN surface. a)-d) As-grown AlN on Al1050; e)-h) After polarization in the Mg-salt (PCM) solution; (SEM) d) and h) elemental mapping of as-grown (d) and corroded (h) surfaces, respectively.
Figure 5: High resolution X-ray photoelectron spectra. As-grown AlN/Al1050 deconvoluted photoelectron peaks of a) Al 2p and b) N 1s. After cyclic polarization in the Mg-salts, AlN/Al1050 deconvoluted photoelectron peaks of c) Al 2p, d) N 1s, e) Cl 2p and f) Mg 2p. (XPS)

### Detailed description of the invention

Making reference to the figures, the present invention refers to a novel cathodic anticorrosive protection of metallic components or an assembled heat exchanger by an anticorrosive coating deposited by a single step industrial scale method. In this invention AlN films were grown by an industrially accessible process, i.e. magnetron sputtering that can guarantee high thermal conductivity requirements, in conjunction with high resistance to corrosion.

The key feature of the invention is a method for the corrosion protection of structural metallic materials of heat exchangers used in thermal energy systems comprising a single step low cost industrial scale method. Aluminium nitride (AlN) coating is deposited either on the metallic components or on an assembled heat exchanger by a suitable industrial-scale method. The method provides a catholic protection against corrosive salt hydrates of which the inorganic PCM are synthesized. AlN coated Al1050 have improved corrosion resistance as compared to uncoated ones, what has been proven by reverse polarization in NaCl and salt hydrates environments.

The method of the invention comprises the steps of:
a) Selecting a heat exchanger component or an assembled heat exchanger and placing the heat exchanger component or an assembled heat exchanger in a high vacuum deposition chamber;
b) Pumping down (evacuating) gas from said deposition chamber, thereby reducing the pressure in said chamber to a value of 8E-4 Pa;
c) Leaking reactive gas or chemical precursors to said deposition chamber, thereby reaching the pressure in said chamber to a value of 2 Pa;
d) Depositing AlN coating in the wurtzite structure on the heat exchanger components or on an assembled heat exchanger.

In a preferred embodiment the said AlN anticorrosive coating is deposited on any metallic component or assembled heat exchanger.

In a further embodiment the AlN anticorrosive coating is deposited by any vapour deposition technique of thickness between 0,5 um to 10000 um.

In a further embodiment 1,5 um thick AlN film in the wurtzite structure is deposited by magnetron sputtering on Al1050 to serve as anticorrosive coating.

In a further embodiment said AlN coating contains metallic nanoparticles for enhanced thermal conductivity.

In a further embodiment in said AlN, amount of AlO incorporates for enhanced corrosion resistance properties.

In a further embodiment a metallic buffer layer can be deposited between the metallic component or assembled heat exchanger and said AlN coating chosen for enhanced adhesion and corrosion protection against specific solutions. In this embodiment, AlN coatings were grown by DC unbalanced reactive magnetron sputtering in a high vacuum chamber (base pressure Pb= 8E-4 Pa, working pressure Pw= 1,8 Pa) . Pure aluminium (purity 99,9995%) was used as a sputtering target. Al (purity 99,999%) and N (purity 99,999%) flows were adjusted by electronic mass flow controllers at 15 and 10 sccm (working pressure Pw= 1,8 Pa), respectively. AlN samples were deposited on commercially available 1 mm thick cold rolled Al1050 (commercially pure Al) sheets. No grinding or polishing processes were performed on the Al1050 sheets.

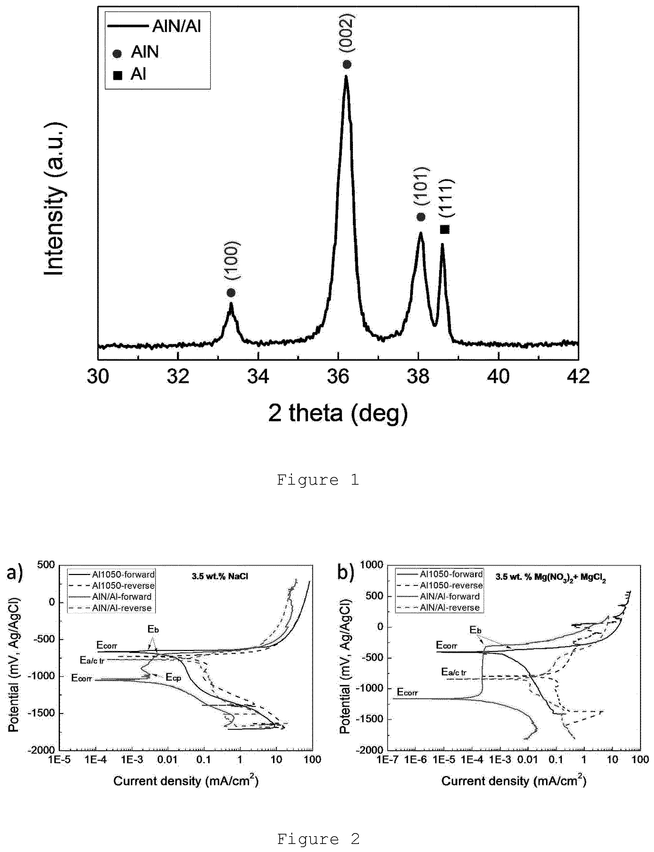

The crystal structure of grown AlN coatings was performed in θ-θ X-ray diffraction (XRD) as shown in figure 1. XRD measurements revealed wurtzite AlN (w-AlN) crystal structure of lattice parameters of a= 3,11 Å and c= 4,97 Å. w-AlN crystals were preferentially grown along the (002) orientation. By applying Scherrer's formula on the (100), (002) and (101) AlN XRD peaks, crystal sizes of 39 nm, 24 nm and 29 were obtained, respectively.

For the corrosion measurements, the AlN coated Al1050 sheets (AlN/Al1050) were encapsulated in PTFE (Polytetrafluoroethylene), leaving a surface area of ~1,5 cm² to be exposed to the electrolytes, at 25°C. Two different electrolytes were used: An inorganic PCM (3,5 wt. % Mg(NO₃)₂+MgCl₂) and 3,5 wt.% NaCl. (Polarization tests in 3,5 wt.% NaCl, a solution that mimics saline environments, were carried out to see the response of the coating to a highly destructive environment for Al). Potentiodynamic polarization tests were performed at the ACM Gill AC potentiostat/galvanostat. A standard three-electrode cell was employed with Ag/AgCl (3,5 M KCl, EAgCl = ESHE - 200 mV, SHE: Standard Hydrogen Electrode) as the reference electrode and a platinum gauze as the counter electrode. The rest potential was determined after 2h of immersion in the electrolytes (open-circuit state). Following determination of the rest potential, polarization started at a scan rate of 10 mV/min. The PCM material, composed of magnesium nitrate and magnesium chloride, was granted by PCM Products Ltd.

The corrosion current densities were calculated by Tafel extrapolation [31,32]. The susceptibility of the alloys to localized corrosion was investigated by reverse polarization. The main concept of this technique is that localized corrosion would occur if the current density of the anodic portion of the return scan is higher than the current density of the forward scan for the same anodic potential [33]. This type of hysteresis is labelled as "negative hysteresis".

The negative hysteresis between the forward and reverse polarization curves in Figure 2a shows that both materials (1 um AlN/Al and Al1050) are susceptible to localized forms of corrosion in 3,5 wt.% NaCl. Nevertheless, the superiority of the localized corrosion behaviour of the AlN coating over that of Al1050 is evident as shown in Figure 2a, namely:
(a) AlN exhibits a passive-like stage (or, more accurately, a current limiting stage) over a small range of anodic potentials (E_{b}-E_{cp}= ~270 mV). On the other hand, the anodic portion of the Al1050 forward polarization curve after polarization at the corrosion potential (E_{corr}) displays a flat gradient, which is sustained for more than three orders of magnitude of the current density. The persistent flat gradient suggests pitting of Al1050;
(b) The passive-like currents of AlN are much lower than 0,1 mA/cm² (current in the middle of passive stage: iₚ= 3E-3 mA/cm²); therefore, the passive films are considered quite protective;
(c) AlN presents nobler anodic-to-cathodic potential (E_{a/c tr}) as compared to the corrosion potential (E_{corr}) (E_{a/c tr}-E_{corr}= ~260 mV), indicating that the resulting surfaces at E_{a/c tr} upon reverse polarization are nobler than those at E_{corr} upon forward polarization; moreover, negative hysteresis turns to positive at E_{a/c tr}. On the other hand, Al presents a lower E_{a/c tr} as compared to E_{corr}.

It should be noted, that Al presents nobler corrosion potential (E_{corr}) than that of the AlN coating. Nevertheless, this result is misleading because the value reported as E_{corr} is not actually the electrochemical potential of Al (in the sense of the potential above which general anodic dissolution of Al would start upon anodic polarization), since, as explained below, Al at the potential of E_{corr} is already in a pitted state.

Figure 2a also shows that Al1050 exhibits a polarization behaviour typical of Al-alloys. The negative hysteresis loop manifests susceptibility to localized corrosion. However, its corrosion potential is almost equal to its pitting potential (E_{b}), as has also been observed in other Al-alloys [34-36]. This behaviour is compatible with the fact that Al-alloys in aerated halide solutions usually manifest corrosion potentials close to their pitting potentials, suggesting that the cathodic oxygen reduction, largely within the flawed regions, is sufficient to raise the corrosion potential to the pitting potential [37]. (In commercially pure Al alloys of the 1xxx series, such as Al1050- and AA1100-H14 [38,39]), these flawed regions are primarily impurities forming intergranular Al-Fe and Al-Fe-Si eutectic intermetallic compounds. The above impurities (being quite nobler than Al) form galvanic couples with adjacent Al, as soon as the semi-conductive alumina-based film on the Al/aluminide or Al/eutectic micro-constituent interface is thinned by dissolution due to the adsorption of the aggressive Cl- anions. Localized dissolution of adjacent Al then occurs resulting in the formation of small pits [39]. It is also well established that Al is subjected to pit corrosion even under cathodic polarization in a solution, by a mechanism that involves hydrogen evolution at the oxide film/metallic-substrate interface, blister formation at the interface and local film breakdown, due to the high pressure of H2 and electrolyte access to the metallic-substrate [40]. Furthermore, even during recording of the open circuit potential in aerated halide solutions, Al is readily polarized to its pitting potential [41].

As far as the uniform corrosion behaviour of the AlN coating is concerned, its corrosion rate (in terms of corrosion current density) was calculated by Tafel extrapolation on the cathodic portion of the forward polarization curve as i_{corr}= 6E-3 mA/cm². It must be mentioned that determination of i_{corr} for Al1050 does not have any practical meaning, since the degradation phenomenon is localized and localized hydrolysis reactions cause local sharp increases in current density.

The negative hysteresis of the polarization curves in Figure 2b, indicate that both materials (AlN/Al and Al1050) have also been subjected to localized corrosion forms, in aqueous Mg(NO₃)₂+MgCl₂, which is a representative salt Hydrate PCM. Figure 2b also manifests that, as in the aqueous NaCl case, the AlN coating exhibits superior behaviour to localized corrosion compared to the Al-substrate. More specifically:
(a) AlN exhibits passivity over a high range of anodic potentials (E_{b}-E_{cp}= ~720 mV); moreover, the almost flat gradient of the anodic portion of Al forward polarization curve after polarization at E_{corr} (E_{corr}≈E_{b}), which is sustained for more than three orders of current density magnitude, denotes that Al is in pitted state even when polarized at its corrosion potential (during cathodic polarization and/or the preceding free corrosion state);
(b) The passive currents of AlN are notably lower than 0,1 mA/cm² (current in the middle of passive stage: iₚ= 2E-4 mA/cm²); therefore, the passive films have very low conductivity (true passivity);
(c) AlN displays nobler E_{a/c tr} as compared to E_{corr} (E_{a/c tr}-E_{corr}= ~320 mV), thus suggesting that the resulting surfaces at E_{a/c tr} upon reverse polarization are nobler than those at E_{corr} upon forward polarization; furthermore, negative hysteresis turns to positive at E_{a/c tr}. By contrast, Al1050 shows a much lower E_{a/c tr} as compared to E_{corr} (by ~400 mV) .

Furthermore, the corrosion current density of the AlN coating has been calculated by Tafel extrapolation on the cathodic portion of the forward polarization curve as i_{corr}= 2E-4 mA/cm² (almost one order of magnitude lower than that in aqueous NaCl) .

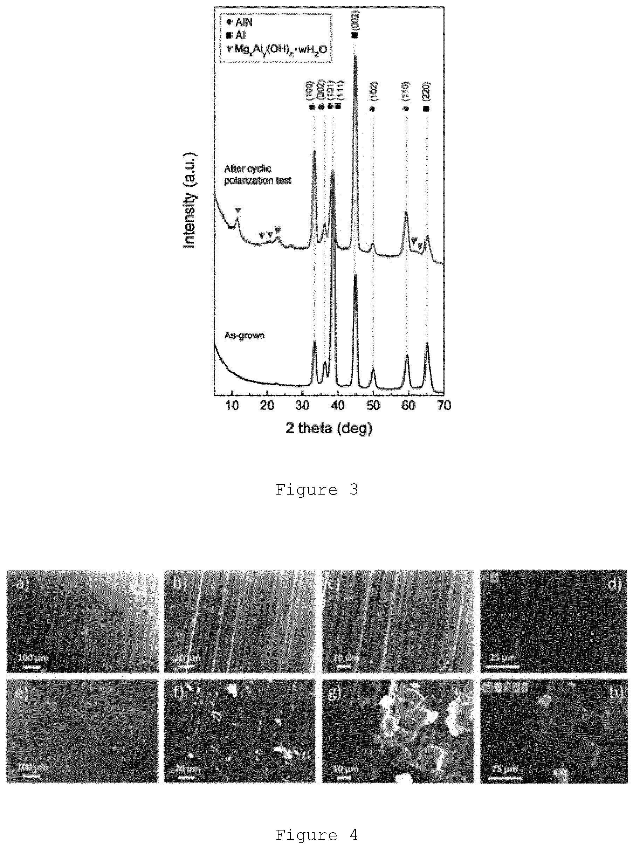

The presence of surface films on the AlN coating after the cyclic polarization tests was confirmed by grazing incidence X-ray diffraction (GID) measurements, as shown in figure 3. In comparison with the as-grown sample, at low diffraction angles, new XRD peaks were detected that were ascribed to surface Mg-Al hydroxide hydrates, as shown in figure 3.

The surface state of the coated specimens before and after cyclic polarization was studied by scanning electron microscopy (SEM) as shown in figure 4. The intensive grooves observed in figures 4a-g have been formed during the cold rolling process of the Al1050 substrate. The surface of the uncorroded specimens consists of Al and N, as expected, figure 4d. The good surface state after cyclic polarization is clearly seen in Figure 4e-g. Figure 4e shows extensive surface deposits consisting of Mg, Al, O, and Cl (Figure 4h) detected by energy dispersive spectroscopy (EDS), in agreement with the XRD findings in Figure 3.

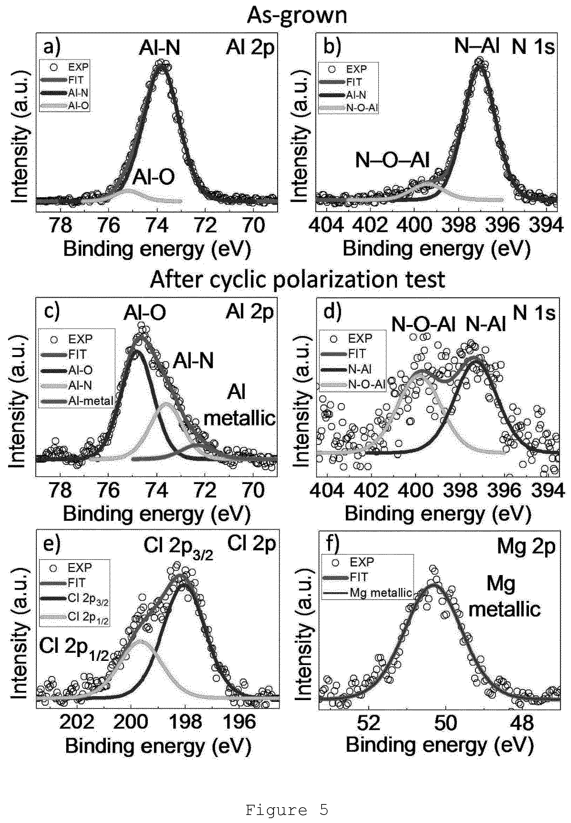

Surface chemical analysis of the AlN coating before and after cyclic polarization tests was obtained by X-ray photoelectron spectroscopy (XPS) to investigate the AlN interaction with the inorganic PCM surface, Figure 5. The XPS wide spectra indicated the presence of Mg and Cl on the surface of the coating after cyclic polarization, in compatibility with Figure 4h.

Figures 5 a,b depicts the high resolution XPS measurements performed on the Al 2p, N 1 and O 1s photoelectron peaks of as-grown AlN/Al1050. The Al 2p photoelectron peak was deconvoluted to a major peak at 73,8 eV and a less intense peak at 75,2 eV binding energy that correspond to Al-N and Al-O chemical bonding, respectively, Figure 5a [42-44]. Similar findings were obtained by the N 1s photoelectron peak analysis; this peak was deconvoluted to two peaks at 397,1 eV and 399,4 eV binding energies that can be attributed to N-Al and N-O-Al chemical bonding, respectively, Figure 5b [43-45]. Additional surface contaminants of C-C, C-O-C and O-C=O were also found at 284,8 eV, 287,2 eV and 289,2 eV binding energies, respectively, by deconvoluting the C 1s photoelectron peak (not shown) [46].

The high resolution XPS measurements on the AlN film surface after cyclic polarization in aqueous Mg(NO₃)₂+MgCl₂ revealed a chemical modification of the surface, figures 5c-5f. For the deconvolution of the Al 2p photoelectron peak, an additional peak was necessary to be used. The peaks at 74,8 eV, 73,6 eV and 72,3 eV binding energies were ascribed to Al-O, Al-N and metallic Al, respectively [42,43,47]. Moreover, the amount of the detected Al-O is higher in comparison to the as-grown sample indicating the formation of a thin oxide layer on the AlN film surface. The detected metallic Al peak could be attributed to a surface formed or attached Al-Mg compound, Figure 5c. The low intensity N 1s peak, which was deconvoluted into two peaks at 397,3 eV and 399,9 eV binding energies, corresponding to N-Al and N-O-Al, respectively, confirm the aforementioned surface thin film formation indications, Figure 5d. The photoelectron peak of Cl 2p was deconvoluted to two peaks at 198,1 eV and 199,6 eV binding energies that correspond to Cl 2p_{3/2} and Cl 3p_{1/2} inorganic compounds, respectively, Figure 5e [48]. Metallic Mg 2p at 50,3 eV binding energy was also found, which, as mentioned before, may be incorporated in an Al-Mg surface compound, Figure 5f [48]. Identical carbon contaminants were observed by analysing the C 1s photoelectron peak (not shown).

The result of the method of the invention is a protective coating of AlN against corrosive salt hydrates (PCM) used in thermal storage applications. Besides the simplicity and the industrial scale method of the presented embodiment for coating by AlN structural elements used in thermal storage applications, another advantage is its high thermal conductivity. This is a significant benefit of utilising AlN as anticorrosive material since the thermal behaviour of PCM can be exploited to the maximum avoiding thermal shielding and thermal loss effects and, moreover, expanding the lifetime of metallic heat exchange components used in thermal storage applications.

### References:

[1] *Thermal Energy Storage for Commercial Applications* - *A Feasibility Study on* I *Springer.*
[2] F. Baylin, "Low temperature thermal energy storage: A state-of-the-art survey," Solar Energy Research Institute, Colorado, USA, SERI/RR/-54-164, 1979.
[3] M. Kenisarin and K. Mahkamov, "Solar energy storage using phase change materials," Renew. Sustain. Energy Rev., vol. 11, no. 9, pp. 1913-1965, Dec. 2007.
[4] M. Mehrali, S. T. Latibari, M. Mehrali, H. S. C. Metselaar, and M. Silakhori, "Shape-stabilized phase change materials with high thermal conductivity based on paraffin/graphene oxide composite," Energy Convers. Manag., vol. 67, pp. 275-282, Mar. 2013.
[5] S. D. Sharma and K. Sagara, "Latent Heat Storage Materials and Systems: A Review," Int. J. Green Energy, vol. 2, no. 1, pp. 1-56, Jan. 2005.
[6] B. Zalba, J. M. Mariń , L. F. Cabeza, and H. Mehling, "Review on thermal energy storage with phase change: materials, heat transfer analysis and applications," *Appl. Therm. Eng.,* vol. 23, no. 3, pp. 251- 283, Feb. 2003.
[7] S. HIMRAN, A. SUWONO, and G. A. MANSOORI, "Characterization of Alkanes and Paraffin Waxes for Application as Phase Change Energy Storage Medium," Energy Sources, vol. 16, no. 1, pp. 117-128, Jan. 1994.
[8] N. Ukrainczyk, S. Kurajica, and J. Šipušić, "Thermophysical Comparison of Five Commercial Paraffin Waxes as Latent Heat Storage Materials," *Chem. Biochem. Eng. Q.,* vol. 24, no. 2, pp. 129-137, Jul. 2010.
[9] D. Banu, D. Feldman, and D. Hawes, "Evaluation of thermal storage as latent heat in phase change material wallboard by differential scanning calorimetry and large scale thermal testing," Thermochim. Acta, vol. 317, no. 1, pp. 39-45, Jul. 1998.
[10] K. Cho and S. H. Choi, "Thermal characteristics of paraffin in a spherical capsule during freezing and melting processes," Int. J. Heat Mass Transf., vol. 43, no. 17, pp. 3183-3196, Sep. 2000.
[11] A. Sharma, S. D. Sharma, and D. Buddhi, "Accelerated thermal cycle test of acetamide, stearic acid and paraffin wax for solar thermal latent heat storage applications," Energy Convers. Manag., vol. 43, no. 14, pp. 1923-1930, Sep. 2002.
[12] "Use of phase change materials for thermal energy storage in concrete: An overview." Available: https://www.academia.edu/3651408/.
[13] J. N. Chiu, V. Martin, and F. Setterwall, "A Review of Thermal Energy Storage Systems with Salt Hydrate Phase Change Materials for Comfort Cooling," presented at the EFFSTOCK 2009, 2009.
[14] F. Kenfack and M. Bauer, "Innovative Phase Change Material (PCM) for Heat Storage for Industrial Applications," Energy Procedia, vol. 46, pp. 310-316, 2014.
[15] S. Haehnlein, P. Bayer, and P. Blum, "International legal status of the use of shallow geothermal energy," Renew. Sustain. Energy Rev., vol. 14, no. 9, pp. 2611-2625, Dec. 2010.
[16] J. M. Marin, B. Zalba, L. F. Cabeza, and H. Mehling, "Improvement of a thermal energy storage using plates with paraffin-graphite composite," Int. J. Heat Mass Transf., vol. 48, no. 12, pp. 2561-2570, Jun. 2005.
[17] J. Wang, H. Xie, Z. Xin, Y. Li, and L. Chen, "Enhancing thermal conductivity of palmitic acid based phase change materials with carbon nanotubes as fillers," Sol. Energy, vol. 84, no. 2, pp. 339-344, Feb. 2010.
[18] F. Agyenim, P. Eames, and M. Smyth, "A comparison of heat transfer enhancement in a medium temperature thermal energy storage heat exchanger using fins," Sol. Energy, vol. 83, no. 9, pp. 1509- 1520, Sep. 2009.
[19] W. Q. Li, Z. G. Qu, Y. L. He, and W. Q. Tao, "Experimental and numerical studies on melting phase change heat transfer in open-cell metallic foams filled with paraffin," Appl. Therm. Eng., vol. 37, pp. 1-9, May 2012.
[20] T. Oya, T. Nomura, N. Okinaka, and T. Akiyama, "Phase change composite based on porous nickel and erythritol," Appl. Therm. Eng., vol. 40, pp. 373-377, Jul. 2012.
[21] J. C. Kurnia, A. P. Sasmito, S. V. Jangam, and A. S. Mujumdar, "Improved design for heat transfer performance of a novel phase change material (PCM) thermal energy storage (TES)," Appl. Therm. Eng., vol. 50, no. 1, pp. 896-907, Jan. 2013.
[22] R. Parameshwaran, S. Kalaiselvam, S. Harikrishnan, and A. Elayaperumal, "Sustainable thermal energy storage technologies for buildings: A review," Renew. Sustain. Energy Rev., vol. 16, no. 5, pp. 2394- 2433, Jun. 2012.
[23] T.-P. Teng and C.-C. Yu, "Characteristics of phase-change materials containing oxide nano-additives for thermal storage," Nanoscale Res. Lett., vol. 7, no. 1, p. 611, Nov. 2012.
[24] S. Shaikh, K. Lafdi, and K. Hallinan, "Carbon nanoadditives to enhance latent energy storage of phase change materials," J. Appl. Phys., vol. 103, no. 9, p. 094302, May 2008.
[25] Y. Cui, C. Liu, S. Hu, and X. Yu, "The experimental exploration of carbon nanofiber and carbon nanotube additives on thermal behavior of phase change materials," Sol. Energy Mater. Sol. Cells, vol. 95, no. 4, pp. 1208-1212, Apr. 2011.
[26] A. Hasan, S. J. McCormack, M. J. Huang, and B. Norton, "Characterization of phase change materials for thermal control of photovoltaics using Differential Scanning Calorimetry and Temperature History Method," Energy Convers. Manag., vol. 81, pp. 322-329, May 2014.
[27] J. N. W. Chiu and V. Martin, "Submerged finned heat exchanger latent heat storage design and its experimental verification," Appl. Energy, vol. 93, pp. 507-516, May 2012.
[28] C. Barreneche, A. Sole, L. Miro, I. Martorell, A. I. Fernandez, and L. F. Cabeza, "Study on differential scanning calorimetry analysis with two operation modes and organic and inorganic phase change material (PCM)," Thermochim. Acta, vol. 553, pp. 23-26, Feb. 2013.
[29] A. Sole, L. Miro, C. Barreneche, I. Martorell, and L. F. Cabeza, "Review of the T-history method to determine thermophysical properties of phase change materials (PCM)," Renew. Sustain. Energy Rev., vol. 26, pp. 425-436, Oct. 2013.
[30] F. C. Porisini, "Salt hydrates used for latent heat storage: Corrosion of metals and reliability of thermal performance," Sol. Energy, vol. 41, no. 2, pp. 193-197, 1988.
[31] L. f. Cabeza, J. Roca, M. Nogues, H. Mehling, and S. Hiebler, "Immersion corrosion tests on metal-salt hydrate pairs used for latent heat storage in the 48 to 58°C temperature range," Mater. Corros., vol. 53, no. 12, pp. 902-907, 2002.
[32] A. J. Farrell, B. Norton, and D. M. Kennedy, "Corrosive effects of salt hydrate phase change materials used with aluminium and copper," J. Mater. Process. Technol., vol. 175, no. 1-3, pp. 198-205, Jun. 2006.
[33] A. Sole, L. Miro, C. Barreneche, I. Martorell, and L. F. Cabeza, "Corrosion Test of Salt Hydrates and Vessel Metals for Thermochemical Energy Storage," Energy Procedia, vol. 48, pp. 431-435, 2014.
[34] "Women in economic decision-making in the EU- A Europe 2020 initiative".
[35] "http://ec.europa.eu/clima/policies/package/index_en.htm"
[36] "Joint EASE/EERA recommendations for a European Energy Storage Technology Development.
   Roadmap towards 2030," EASE (European Association for the Storage of Energy) and EERA (European Energy Research Alliance), Brussels, Belgium, 2013.
[37] "EC Energy Roadmap 2050."
[38] "Directive of the European Parliament and of the Council 2009/28/EC, on the promotion of the use of energy from renewable sources and amending and subsequently repealing Directives 2001/77/EC and 2003/30/ECeRES directive."
[39] EHPA, European Heat Pump Association, "Outlook 2011 European Heat Pump Statistics."
[40] DG ENER Working Paper, "The future role and challenges of Energy Storage," EUROPEAN COMMISSION, DIRECTORATE-GENERAL FOR ENERGY.
[41] Buddhi D, "Thermal performance of a shell and tube PCM storage heat exchanger for industrial waste heat recovery," Present. Sol. World Concur.
[42] H. L. Zhang, J. Baeyens, J. Degreve, G. Caceres, R. Segal, and F. Pitie, "Latent heat storage with tubularencapsulated phase change materials (PCMs)," Energy, vol. 76, pp. 66-72, Nov. 2014.
[43] P. B. Salunkhe and P. S. Shembekar, "A review on effect of phase change material encapsulation on the thermal performance of a system," Renew. Sustain. Energy Rev., vol. 16, no. 8, pp. 5603-5616, 2012.
[44] M. Rahimi, A. A. Ranjbar, D. D. Ganji, K. Sedighi, and M. J. Hosseini, "Experimental Investigation of Phase Change inside a Finned-Tube Heat Exchanger," J. Eng., vol. 2014, p. e641954, Oct. 2014.
[45] P. Rocha, A. Siddiqui, and M. Stadler, "Improving energy efficiency via smart building energy management systems: A comparison with policy measures," Energy Build., vol. 88, pp. 203-213, Feb. 2015.
[46] A. Broy and C. Sourkounis, "Guidelines for renewable energy based supply system for various types of buildings," in Energy Conference (ENERGYCON), 2014 IEEE International, 2014, pp. 968-974.
[47] Vasiliva, I., Broy, A, and Sourkounis, C, "Design Rules for Autonomous Hybrid Energy Supply Systems for Various Types of Buildings in Central Europe," POEM 2013*.*
[48] B. Sanner, C. Karytsas, D. Mendrinos, and L. Rybach, "Current status of ground source heat pumps and underground thermal energy storage in Europe," Geothermics, vol. 32, no. 4-6, pp. 579-588, Aug. 2003.

## Claims

1. Method for corrosion protection of metallic heat exchanger components or assembled heat exchanger wherein an anticorrosive coating is deposited by a magnetron sputtering technique comprising the following steps:
a) Selecting a heat exchanger component or an assembled heat exchanger and placing the heat exchanger component or the assembled heat exchanger in a high vacuum deposition chamber;
b) Evacuating gas from the high vacuum deposition chamber, reducing the pressure in the deposition chamber to a value of 8E-4 Pa;
c) Leaking reactive gas or chemical precursors to the high vacuum deposition chamber, reaching the pressure in the vacuum deposition chamber to a value of 2 Pa;
d) Depositing an AlN coating in a wurtzite structure on the heat exchanger components or assembled heat exchanger.

2. Method according to any of the previous claims, wherein the AlN coating has a thickness from 0,5 um to 10000 µm.

3. Use of the method claimed in claims 1 to 2 in the application of an anticorrosion protective coating against salt hydrates PCM in heat exchangers and thermal energy systems.

## Patentansprüche

1. Verfahren zum Korrosionsschutz von metallischen Wärmetauscherkomponenten oder zusammengesetzten Wärmetauschern, bei dem eine Antikorrosionsbeschichtung durch ein Magnetron-Sputterverfahren abgeschieden wird, umfassend die folgenden Schritte:
a) Auswahl einer Wärmetauscherkomponente oder eines zusammengesetzten Wärmetauschers und Einbringen der Wärmetauscherkomponente oder des zusammengesetzten Wärmetauschers in eine Hochvakuum-Beschichtungskammer;
b) Evakuierung des Gases aus der Hochvakuum-Beschichtungskammer, wodurch der Druck in der Beschichtungskammer auf einen Wert von 8E-4 Pa gesenkt wird;
c) Einleitung von reaktivem Gas oder chemischen Grundstoffen in die Hochvakuum-Beschichtungskammer, wodurch der Druck in der Vakuum-Beschichtungskammer auf einen Wert von 2 Pa steigt;
d) Aufbringen einer AlN-Beschichtung in Wurtzit-Struktur auf die Wärmetauscherkomponenten oder den zusammengesetzten Wärmetauscher.

2. Verfahren nach einem der vorhergehenden Ansprüche, wobei die AlN-Beschichtung eine Dicke von 0,5 µm bis 10000 µm aufweist.

3. Verwendung des Verfahrens nach den Ansprüchen 1 bis 2 zum Aufbringen einer Korrosionsschutzschicht gegen PCM-Salzhydrate in Wärmetauschern und thermischen Energiesystemen.

## Revendications

1. Procédé de protection contre la corrosion des composants métalliques d'un échangeur de chaleur ou d'un échangeur de chaleur assemblé, dans lequel un revêtement anticorrosion est déposé par une technique de pulvérisation au magnétron, comprenant les étapes suivantes :
a) Sélectionner un composant d'échangeur de chaleur ou d'un échangeur de chaleur assemblé et installer le composant d'échangeur de chaleur ou l'échangeur de chaleur assemblé dans un compartiment de dépôt sous vide poussé;
b) Évacuer le gaz du compartiment de dépôt sous vide poussé en réduisant la pression dans le compartiment de dépôt à une valeur de 8E-4 Pa;
c) Laisser s'échapper le gaz réactif ou les précurseurs chimiques dans le compartiment de dépôt sous vide poussé, et atteindre une pression de 2 Pa dans le compartiment de dépôt sous vide;
d) Déposer un revêtement AlN dans une structure de wurtzite sur les composants de l'échangeur de chaleur ou sur l'échangeur de chaleur assemblé.

2. Procédé selon l'une quelconque des revendications précédentes, dans lequel le revêtement AlN a une épaisseur comprise entre 0,5 um et 10000 um.

3. Utilisation du procédé selon les revendications 1 à 2 dans l'application d'un revêtement de protection anticorrosion contre les hydrates de sel PCM dans les échangeurs de chaleur et les systèmes d'énergie thermique.
